# EUROPÄISCHE PATENTSCHRIFT

(11) **EP 0 649 273 B1**
(45) Veröffentlichungstag und Bekanntmachung des Hinweises auf die Patenterteilung: **21.08.1996**
(21) Anmeldenummer: 94115754.7
(22) Anmeldetag: 06.10.1994
(51) Int. Cl.: H05K 3/10, H05K 9/00

(54) **Verfahren zur Herstellung eines elektrischen Kontakts**
Process of making an electrical contact
Procédé pour fabriquer un contact électrique

(30) Priorität: 13.10.1993 DE 4334875
(43) Veröffentlichungstag der Anmeldung: 19.04.1995
(73) Patentinhaber: HOECHST AKTIENGESELLSCHAFT, 65929 Frankfurt am Main (DE)
(72) Erfinder: Pfeiffer, Bernhard, Dr., D-65779 Kelkheim (DE); Skaletz, Detlef, Dr., D-55128 Mainz (DE)

(56) Entgegenhaltungen:
- WO-A-88/06342
- DE-A- 2 605 257
- DE-U- 8 633 771
- US-A- 4 880 679
- US-A- 5 075 034
- US-A- 5 248 553
- PATENT ABSTRACTS OF JAPAN vol. 11, no. 262 (C-442) 25. August 1987 & JP-A-62 062 872 (SEIKO) 19. März 1987
- PATENT ABSTRACTS OF JAPAN vol. 11, no. 262 (C-442) 25. August 1987 & JP-A-62 062 872

## Beschreibung

Die Erfindung betrifft ein Verfahren zur Herstellung eines elektrischen Kontakts an einem elektrisch leitfähigen Formkörper aus metallfaserhaltigen Thermoplastwerkstoffen, siehe z.B. US-A-4880679.
Thermoplastwerkstoffe, die mit Metallfasern gefüllt sind, werden unter anderem für Heizelemente (Flächenheizleiter), abschirmende Gehäuse und antistatisch ausgerüstete Bauteile verwendet. Bei der Herstellung solcher Formkörper durch Spritzgießen oder durch Extrusion gelangen die leitfähigen Metallfasern nicht in ausreichender Konzentration unmittelbar an die Oberfläche. Die sich an der Oberfläche ausbildende an Metallfasern verarmte, weniger leitfähige Schicht erschwert die Anbringung von elektrischen Kontakten. Bei Formkörpern aus den gleichen Materialien, bei denen Oberflächen durch Sägen erzeugt wurden, tritt dieses Problem nicht auf.
Üblicherweise werden deshalb die elektrischen Kontakte durch Bohren der Formkörper und nachfolgendes Einpressen von Metallbuchsen oder Metallstiften oder durch Eindrehen von selbstschneidenden Metallschrauben angebracht. Diese bekannten Methoden der Anbringung von Kontakten sind arbeits- und materialaufwendig.
Es bestand daher die Aufgabe, ein Verfahren anzugeben, mit dem sich elektrische Kontakte in einfacher Form auf elektrisch leitfähigen Formkörpern herstellen lassen.
Es wurde nun ein Verfahren zur Herstellung eines elektrischen Kontakts an einem elektrisch leitfähigen Formkörper gefunden, das dadurch gekennzeichnet ist, daß man auf der Oberfläche eines elektrisch leitfähigen Formkörpers aus thermoplastischen Material, das Metallfasern enthält, eine Suspension aufträgt, die ein elektrisch leitfähiges Pulver sowie ein Lösungsmittel enthält, das das thermoplastische Material des Formkörpers anlöst oder aufquillt und man die
aufgetragene Suspension eintrocknen läßt.
Das verwendete Lösemittel ist vorzugsweise ein organisches Lösemittel.
Polypropylensulfid läßt sich etwas durch chlorierte Kohlenwasserstoffe anlösen. Polybutylenterephthalat läßt sich etwas durch chlorierte Kohlenwasserstoffe, Ester und Aldehyde, insbesondere aber durch Ketone, wie Aceton anlösen. Polyamide lassen sich etwas durch chlorierte Kohlenwasserstoffe, Ketone und Terpetin anlösen. Polypropylen läßt sich etwas durch Ester, Ketone und aromatische Kohlenwasserstoffe, insbesondere aber durch chlorierte Kohlenwasserstoffe, Äther und Terpentin anlösen. Polycarbonat läßt sich etwas durch Ester und Ketone, insbesondere aber durch chlorierte Kohlenwasserstoffe, Äther und Aldehyde anlösen. ABS-Kunstoffe lassen sich durch alle der genannten Lösemittel gut anlösen.
Es ist auch möglich, einige Kunststoffe (insbesondere Polyamid, Polypropylen und ABS-Kunststoffe) durch oxidierende Säuren anzuätzen und so die Oberfläche der (in diesem Fall säurebeständigen) Metallfasern freizulegen.
Das elektrisch leitfähige Pulver ist vorzugsweise ein Metallpulver, insbesondere Silber-Pulver, oder Ruß. Die Metallfasern des thermoplastischen Materials bestehen vorzugsweise aus Kupfer, Stahl und insbesondere rostfreiem Stahl.
Die zu behandelnden Formkörper können beliebige Form aufweisen. Besonders bevorzugt sind Formkörper in Gehäuse- und Plattenform. In diesen Fällen ist es möglich, mit Hilfe der Suspension eine Metallfolie auf die Oberfläche des Formkörpers aufzukleben, die den elektrischen Kontakt darstellt.
Die aufgetragene Suspension kann auch eine zusätzliche Klebekomponente enthalten. Vorzugsweise stellt diese ein organisches Polymer dar, das in dem verwendeten Lösemittel löslich ist. Das Abbinden des Klebstoffes geschieht durch Verdunsten des Lösemittels.
Daneben ist das Abbinden durch chemische Reaktion möglich. Hierbei können Phenol- und Carbamid-Formaldehydharze, Epoxid-Harze, ungesättigte Polyesterharze, Polyurethane, Polysulfide und Silicone zum Einsatz kommen.

Bei hohlen Formkörpern wird häufig verlangt, daß sie eine gute Abschirmung gegen elektromagnetische Strahlung aufweisen, damit elektronische Schaltungen (z.B. in der Kfz-Industrie die empfindliche elektronische Schaltung des Anti-Blockier-Systems), die im Inneren angeordnet werden, ungestört funktionieren. Dies setzt voraus, daß die Einzelteile, aus denen sich der Formkörper zusammensetzt, durch elektrische Kontakte verbunden sind, und an den Berührungspunkten keine Undichtigkeiten für elektromagnetische Strahlung auftreten.
Falls der Formkörper die Form eines Gehäuses hat, das aus zwei Schalen zusammengesetzt wird, kann man an den Berührungsstellen der Schalen die oben angegebene Suspension aufbringen, die Gehäuseschalen zu dem Gehäuse zusammensetzen und gegebenenfalls unter Druck zusammenpressen.

Man kann auch an der Berührungsstelle zweier Gehäuseschalen eine dünne metallische Zwischenschicht einkleben, die eine nach außen ragende Kontaktfahne aufweisen kann. Auf diese Weise kann z.B. das zusammengesetzte Gehäuse geerdet werden. Zur Kontaktierung kann man auch an mindestens einer Gehäuseschale in Nähe der Berührungsstelle einen außenliegenden Bereich mit der Suspension bestreichen, die ein elektrisch leitfähiges Pulver enthält. Nach Eintrocknen der Suspension entsteht ein äußerer elektrischer Kontakt an dem geschlossenen Gehäuse.

Eine besonders gute mechanische Verbindung der beiden Gehäuseschalen wird erreicht, wenn die Gehäuseschalen ineinandergreifen, z.B. wie Nut und Feder oder durch Bajonettverschluß gesichert sind.
Nach einer anderen Ausgestaltung des erfindungsgemäßen Verfahrens kann man eine Gehäuseschale, die aus einem mit Metallfasern gefüllten thermoplastischen Material besteht, mit Hilfe der oben erwähnten Suspension so auf eine Leiterplatine aufkleben, auf der eine elektrische Schaltung angeordnet ist, daß die elektrische Schaltung allseitig umschlossen wird. Falls die Leiterplatine auf der Außenseite metallisiert ist, kann auch das Eindringen von elektromagnetischer Strahlung durch die Leiterplatte hindurch vermieden werden.
Falls der Formkörper die Form eines Gehäuses hat, das aus zwei Schalen zusammengesetzt wird, kann man auch jeweils die Berührungstellen zweier zusammengehöriger Schalen mit der Suspension bestreichen, die Suspension eintrocknen lassen und dann das Gehäuse an den metallisierten Stellen zusammensetzen. Ein solches Gehäuse läßt sich leicht wieder öffnen. Falls die beiden Gehäuseschalen nicht ineinandergreifen, werden die Teile vorteilhafterweise durch eine Feder aneinandergepreßt, um ein Lösen zu verhindern. Auch hier kann man wieder an mindestens eine Gehäuseschale in Nähe der Berührungsstelle einen außenliegenden Bereich mit der Suspension bestreichen, um einen äußeren Kontakt herzustellen. Ebenso kann man beim Zusammensetzen des Gehäuses zwischen zwei Gehäuseschalen eine Metallzwischenschicht oder leitfähige Dichtung einlegen, die eine äußere Kontaktfahne aufweisen kann.

Die Erfindung ermöglicht es, Außenkontakte aus entsprechenden Formkörpern in einfacher Weise mit wenigen Arbeitsgängen herzustellen. Die Verbindung zu den Gegenkontakten kann in üblicher Form z.B. durch Löten, Kleben mit leitenden Klebern oder durch mechanische Verbindung (Metallfedern) erfolgen.
Das Aufbringen der Suspension auf die Oberfläche eines elektrisch leitfähigen Formkörpers erfolgt durch dosiertes Auftropfen, Tauchen oder auch Streichen.
Beim Anlösen oder Aufquellen der Oberflächenschicht durch das Lösungsmittel wird auch das Durchdringen der Oberflächenschicht mit dem leitfähigen Füllstoff ermöglicht.
Die eingesetzten Formkörper können zusätzlich mit Glasfasern verstärkt sein, was sich günstig auf die mechanische Festigkeit auswirkt. Die in den Formkörpern eingesetzten Fasern aus Metall können ganz oder teilweise durch Kohlenstoffasern ersetzt werden.

## Patentansprüche

1. Verfahren zur Herstellung eines elektrischen Kontakts an einem elektrisch leitfähigen Formkörper, dadurch gekennzeichnet, daß man auf der Oberfläche eines elektrisch leitfähigen Formkörpers aus thermoplastischem Material, der Metallfasern enthält, eine Suspension aufträgt, die ein elektrisch leitfähiges Pulver sowie ein Lösungsmittel enthält, das das thermoplastische Material des Formkörpers anlöst oder aufquillt und man die aufgetragene Suspension eintrocknen läßt.

2. Verfahren nach Anspruch 1, dadurch gekennzeichnet, daß als elektrisch leitfähiges Pulver ein Metallpulver und/oder Ruß eingesetzt wird.

3. Verfahren nach Anspruch 1, dadurch gekennzeichnet, daß das thermoplastische Material des Formkörpers Stahlfasern enthält.

4. Verfahren nach Anspruch 1, dadurch gekennzeichnet, daß man eine Gehäuseschale auf einer Leiterplatine, auf der eine elektrische Schaltung angeordnet ist, so aufklebt, daß die elektrische Schaltung allseitig umschlossen wird.

5. Verfahren nach Anspruch 1, dadurch gekennzeichnet, daß der elektrisch leitfähige Formkörper Plattenform aufweist.

6. Verfahren nach Anspruch 5, dadurch gekennzeichnet, daß man mit Hilfe der Suspension eine Metallfolie auf dem plattenförmigen Formkörper aufklebt.

7. Verfahren nach Anspruch 1, dadurch gekennzeichnet, daß die aufgetragene Suspension auch eine Klebekomponente enthält.

8. Verfahren nach Anspruch 7, dadurch gekennzeichnet, daß die Klebekomponente ein organisches Polymer darstellt, das in dem verwendeten Lösemittel gelöst werden kann.

9. Verfahren nach Anspruch 1, dadurch gekennzeichnet, daß der Formkörper die Form eines Gehäuses hat, das aus zwei Schalen zusammengesetzt wird, man die Berührungsstellen zweier Schalen mit der Suspension bestreicht, man die Gehäuseschalen zu dem Gehäuse zusammensetzt bzw. unter Druck zusammenpreßt und die Suspension eintrocknen läßt.

10. Verfahren nach Anspruch 9, dadurch gekennzeichnet, daß man an der Berührungsstelle zweier Gehäuseschalen eine dünne metallische Zwischenschicht einklebt, die eine nach außen ragende Kontaktfahne aufweisen kann.

11. Verfahren nach Anspruch 9, dadurch gekennzeichnet, daß man an mindestens einer Gehäuseschale in Nähe der Berührungsstelle einen außenliegenden Bereich mit der Suspension bestreicht.

12. Verfahren nach Anspruch 9, dadurch gekennzeichnet, daß die beiden Gehäuseschalen ineinandergreifen.

13. Verfahren nach Anspruch 1, dadurch gekennzeichnet, daß der Formkörper die Form eines Gehäuses hat, das aus zwei Schalen zusammengesetzt wird, man die Berührungsstellen zweier zusammengehöriger Schalen mit der Suspension bestreicht, die Suspension eintrocknen läßt und dann das Gehäuse zusammensetzt.

14. Verfahren nach Anspruch 13, dadurch gekennzeichnet, daß man an mindestens einer Gehäuseschale in Nähe der Berührungsstelle einen außen liegenden Bereich mit der Suspension bestreicht, um einen äußeren Kontakt herzustellen.

15. Verfahren nach Anspruch 13, dadurch gekennzeichnet, daß man beim Zusammensetzen des Gehäuses zwischen zwei Gehäuseschalen eine Metallzwischenschicht oder leitfähige Dichtung einlegt, die eine äußere Kontaktfahne aufweisen kann.

## Claims

1. A method for producing an electrical contact on an electrically conductive molding, wherein a suspension is applied onto the surface of an electrically conductive molding made of thermoplastic material which contains metal fibers, which suspension contains an electrically conductive powder and a solvent which solubilizes or causes to swell the thermoplastic material of the molding and the applied suspension is allowed to dry.

2. The method as claimed in claim 1, wherein a metal powder and/or carbon black is used as the electrically conductive powder.

3. The method as claimed in claim 1, wherein the thermoplastic material of the molding contains steel fibers.

4. The method as claimed in claim 1, wherein a housing shell is bonded on a printed circuit board, on which an electrical circuit is arranged, such that the electrical circuit is enclosed on all sides.

5. The method as claimed in claim 1, wherein the electrically conductive molding is of plate form.

6. The method as claimed in claim 5, wherein a metal film is bonded on the plate-form molding with the aid of the suspension.

7. The method as claimed in claim 1, wherein the applied suspension also contains an adhesive component.

8. The method as claimed in claim 7, wherein the adhesive component is an organic polymer which can be dissolved in the solvent used.

9. The method as claimed in claim 1, wherein the molding has the form of a housing which is assembled from two shells, the suspension is spread on the contact region of the two shells, the housing shells are assembled to form the housing or pressed together under pressure and the suspension is allowed to dry.

10. The method as claimed in claim 9, wherein a thin metallic intermediate layer is bonded on in the contact region of the two housing shells, which layer may have an outwardly projecting contact lug.

11. The method as claimed in claim 9, wherein the suspension is spread on an outlying area on at least one housing shell in the vicinity of the contact region.

12. The method as claimed in claim 9, wherein the two housing shells mutually engage.

13. The method as claimed in claim 1, wherein the molding has the form of a housing which is assembled from two shells, the suspension is spread on the contact regions of the two associated shells, the suspension is allowed to dry and the housing is then assembled.

14. The method as claimed in claim 13, wherein the suspension is spread on an outlying area on at least one housing shell in the vicinity of the contact region, in order to produce an outer contact.

15. The method as claimed in claim 13, wherein a metal intermediate layer or conductive seal, which may have an outer contact lug, is inserted between two housing shells during the assembly of the housing.

## Revendications

1. Procédé pour fabriquer un contact électrique sur un corps moulé électro-conducteur, caractérisé en ce que l'on applique sur la surface d'un corps moulé électro-conducteur en matière thermoplastique, qui contient des fibres métalliques, une suspension qui contient une poudre électro-conductrice de même qu'un solvant qui attaque ou fait gonfler la matière thermoplastique du corps moulé et en ce que l'on fait sécher la suspension appliquée.

2. Procédé selon la revendication 1, caractérisé en ce que l'on utilise comme poudre électro-conductrice, une poudre métallique et/ou du noir de carbone.

3. Procédé selon la revendication 1, caractérisé en ce que la matière thermoplastique du corps moulé contient des fibres d'acier.

4. Procédé selon la revendication 1, caractérisé en ce que l'on colle une coquille de boîtier sur une carte imprimée, sur laquelle un circuit électrique est agencé, de façon que le circuit électrique soit enfermé de tous côtés.

5. Procédé selon la revendication 1, caractérisé en ce que le corps moulé électro-conducteur présente la forme d'une plaque.

6. Procédé selon la revendication 5, caractérisé en ce que l'on colle, à l'aide de la suspension, une feuille métallique sur le corps moulé en forme de plaque.

7. Procédé selon la revendication 1, caractérisé en ce que la suspension appliquée contient également une composante adhésive.

8. Procédé selon la revendication 7, caractérisé en ce que la composante adhésive représente un polymère organique qui peut être dissout dans le solvant utilisé.

9. Procédé selon la revendication 31, caractérisé en ce que le corps moulé a la forme d'un boîtier qui se compose de deux coquilles, en ce que l'on recouvre avec la suspension les points de contact des deux coquilles, en ce que l'on assemble les coquilles de boîtier au boîtier, respectivement les presse l'une contre l'autre sous pression et fait sécher la suspension.

10. Procédé selon la revendication 9, caractérisé en ce que l'on colle une mince couche intermédiaire métallique sur le point de contact des deux coquilles de boîtier, laquelle peut présenter un drapeau de contact qui fait saillie vers l'extérieur.

11. Procédé selon la revendication 9, caractérisé en ce que l'on recouvre avec la suspension, sur au moins une coquille de boîtier, à proximité du point de contact, une zone s'étendant extérieurement.

12. Procédé selon la revendication 9, caractérisé en ce que les deux coquilles de boîtier s'emboîtent.

13. Procédé selon la revendication 1, caractérisé en ce que le corps moulé a la forme d'un boîtier qui se compose de deux coquilles, en ce que l'on recouvre avec la suspension les points de contact des deux coquilles allant de paire, fait sécher la suspension, puis assemble le boîtier.

14. Procédé selon la revendication 13, caractérisé en ce que l'on recouvre avec la suspension, sur au moins une coquille de boîtier, à proximité du point de contact, une zone s'étendant extérieurement, afin de fabriquer un contact extérieur.

15. Procédé selon la revendication 13, caractérisé en ce que, lors de l'assemblage du boîtier, on introduit entre deux coquilles de boîtier une couche intermédiaire métallique, ou un joint conducteur, qui peut présenter un drapeau de contact extérieur.
